# EUROPEAN PATENT APPLICATION

(11) **EP 2 244 319 A1**
(43) Date of publication of application: **27.10.2010**
(21) Application number: 10250791.0
(22) Date of filing: 19.04.2010
(51) Int. Cl.: H01M 2/20, H01M 2/34, H01M 10/48, G01R 31/36, H01M 10/42

(54) **Battery module, battery system and electric vehicle**

(30) Priority: 24.04.2009 JP 2009106440
(71) Applicant: Sanyo Electric Co., Ltd., Osaka 570-8677 (JP)
(72) Inventor: Kishimoto, Keiji, Moriguchi City, Osaka, 570-8677 (JP); Nishihara, Yoshitomo, Moriguchi City, Osaka, 570-8677 (JP); Ohkura, Kazumi, Moriguchi City, Osaka, 570-8677 (JP); Taguchi, Kenji, Moriguchi City, Osaka, 570-8677 (JP)
(74) Representative: Calderbank, Thomas Roger

(57) **Abstract**

A battery module includes a plurality of battery cells, and includes a voltage bus bar and a voltage/current bus bar that connect electrodes of the plurality of battery cells to one another. Solder traces are formed in regions that are spaced apart from each other in the voltage/current bus bar. Furthermore, the battery module includes an amplifying circuit and a detecting circuit. The amplifying circuit amplifies a voltage between the solder traces formed in the voltage/current bus bar. The detecting circuit detects the voltage between the solder traces amplified by the amplifying circuit.

## Description

The present invention relates to a battery module, and a battery system and an electric vehicle including the same.

Battery modules capable of being charged and discharged are used as driving sources of movable objects such as electric automobiles. Such a battery module includes a plurality of batteries (battery cells) connected in series, for example.

Users of the movable object including the battery module need to know the remaining amount of battery capacity (charged capacity) of the battery module. In addition, it is necessary to prevent overcharge and overdischarge of each cell constituting the battery module at the time of charging and discharging the battery module. Therefore, a device for monitoring a state of the battery module has been proposed (see JP 8-162171 A, for example).

JP 8-162171 A describes the monitoring device of a battery pack including the plurality of modules connected in series. The monitoring device is provided with a plurality of voltage measuring units that correspond to the plurality of battery modules, respectively, included in the battery pack. Each voltage measuring unit includes a voltage detecting circuit connected to a positive electrode terminal and a negative electrode terminal of the corresponding battery module. Thus, the voltage between the both terminals of the battery module is detected by the voltage detecting circuit.

It is preferable to not only monitor the voltage between the both terminals but monitor a current flowing through the battery module for monitoring a state of the battery module, because monitoring more information as the state of each battery module allows more precise control of the battery pack. However, providing current detecting circuits between the battery modules for monitoring the current flowing through the battery modules leads to a complicated configuration of the monitoring device.

An object of the present invention is to provide a battery module capable of detecting a current flowing through a plurality of battery cells with a simple configuration, and a battery system and an electric vehicle including the same.
(1) According to an aspect of the present invention, a battery module includes a plurality of battery cells, a connecting member arranged to connect at least two electrodes of the plurality of battery cells to each other, and a voltage detector arranged to detect a voltage between a first region and a second region of the connecting member that are spaced apart from each other.
   In the battery module, the at least two electrodes of the plurality of battery cells are connected to each other through the connecting member. The voltage between the first region and the second region of the connecting member that are spaced apart from each other is detected by the voltage detector.
   A value of a current flowing between the first region and the second region of the connecting member can be calculated based on the voltage detected by the voltage detector and resistance between the first region and the second region of the connecting member. This allows the current flowing through the plurality of battery cells to be detected with a simple configuration.
(2) The battery module may further include a circuit board that includes first and second conductor traces that are electrically connected to the voltage detector, wherein the connecting member may be a metal plate arranged to connect electrodes of adjacent battery cells to each other, the metal plate may have the first and second regions, and the first and second regions of the metal plate may be joined to the first and second conductor traces of the circuit board, respectively.
   In this case, the first and second regions of the metal plate are joined to the first and second conductor traces of the circuit board, respectively. Therefore, connecting lines for electrically connecting the first and second regions of the metal plate and the first and second conductor traces of the circuit board are not required. This allows the battery module to be easily manufactured with a simple configuration.
   Moreover, part of the metal plate can be used as shunt resistance for current detection.
   Thus, the current can be detected while the electrodes of the adjacent battery cells can be reliably connected through the metal plate.
   The connecting member may be a metal plate arranged to connect electrodes of adjacent battery cells to each other, and the first and second regions may be provided in the metal plate at a distance from each other between the electrode of one battery cell and the electrode of the other battery cell of the two adjacent battery cells.
   In this case, part of the metal plate can be used as the shunt resistance for current detection. Accordingly, the current can be detected while the electrodes of the adjacent battery cells can be reliably connected to each other through the metal plate.
   The first and second regions may be provided in the metal plate to extend substantially parallel to each other.
   In this case, a sufficient resistance value required for detecting the current can be ensured in part of the metal plate.
(3) The circuit board may include a flexible member, and the first and second conductor traces may be provided on the flexible member.
   In this case, since the first and second conductor traces are provided on the flexible member, short circuits of the first and second conductor traces are sufficiently prevented, and the first and second conductor traces and the first and second regions are reliably connected to each other, respectively.
(4) The circuit board may further include first and second conductive plates which are provided on the flexible member so as to be separated from each other and to which the first and second conductor traces are connected, respectively, the metal plate may include a first attachment portion including the first region and a second attachment portion including the second region, and the first and second conductive plates of the circuit board may be attached to the first and second attachment portions, respectively.
   In this case, the first and second conductive plates of the circuit board are attached to the first and second attachment portions, respectively, so that the first and second conductive plates and the first and second attachment portions are electrically connected to each other, respectively.
   The first and second conductor traces are connected to the first and second conductive plates, respectively, thus eliminating the necessity of using connecting lines for connecting the first and second regions and the first and second conductor traces, respectively. This allows the battery module to be easily manufactured with a simple configuration.
(5) The plurality of battery cells may include at least three battery cells, the connecting member may include a plurality of metal plates, each of which connects electrodes of adjacent battery cells to each other such that the at least three battery cells are connected in series, the first and second regions may be provided in at least one of the plurality of metal plates, and the voltage detector may detect voltages of the plurality of battery cells by detecting voltages among the plurality of metal plates and detect the voltage between the first and second regions.
   In this case, the voltages among the plurality of metal plates are detected by the voltage detector to detect the voltage between the terminals of each battery cell. In addition, the voltage between the first and second regions of the at least one metal plate of the plurality of metal plates is detected by the voltage detector. Thus, the voltage between the terminals of each battery cell can be detected and the current flowing through the plurality of battery cells can be detected by the common voltage detector.
   Moreover, the at least one metal plate can be used for detecting the voltage between the terminals of the battery cell and the current flowing through the battery cell, thus resulting in a simplified configuration.
(6) The battery module may further include an amplifying circuit arranged to amplify the voltage between the first and second regions, wherein the voltage detector may include a plurality of input terminals arranged to receive voltages of the plurality of connecting members or an output voltage of the amplifying circuit, and include a reference terminal held at a reference voltage of the voltage detector, and the first region may be connected to the reference terminal.
   In this case, the voltage between the first and second regions is amplified by the amplifying circuit. The first region is connected to the reference terminal of the voltage detector. Thus, the voltage between the first and second regions can be sufficiently amplified to a high value without using an expensive amplifying circuit having a large operating voltage range. Since the expensive amplifying circuit need not be used, lower cost can be achieved.
(7) The battery module may further include a storage arranged to store a resistance value between the first region and the second region of the connecting member, a current calculator arranged to calculate a current flowing between the first region and the second region based on the voltage detected by the voltage detector and the resistance value stored in the storage, and a temperature detector arranged to detect a temperature of the plurality of battery cells, wherein the current calculator corrects the resistance value stored in the storage based on the temperature detected by the temperature detector.
   In this case, the temperature of the plurality of battery cells is detected, and the resistance value between the first region and the second region stored in the storage is corrected based on the detected temperature. This allows the value of the current flowing between the first region and the second region of the connecting member to be accurately calculated based on the voltage detected by the voltage detector and the corrected resistance value.
(8) According to another aspect of the present invention, a battery system includes a battery module, and a current calculator, wherein the battery module includes a plurality of battery cells, a connecting member arranged to connect at least two electrodes of the plurality of battery cells to each other, and a voltage detector arranged to detect a voltage between a first region and a second region of the connecting member that are spaced apart from each other, and the current calculator calculates a current flowing through the connecting member based on the voltage between the first and second regions detected by the voltage detector of the battery module.
   In the battery system, the current flowing through the connecting member is calculated by the current calculator based on the voltage between the first and second regions detected by the voltage detector of the battery module according to the one aspect of the present invention.
   In the battery module, the at least two electrodes of the plurality of battery cells are connected to each other through the connecting member. The voltage between the first region and the second region of the connecting member that are spaced apart from each other is detected by the voltage detector.
   A value of a current flowing between the first region and the second region of the connecting member is calculated by the current calculator based on the voltage detected by the voltage detector and resistance between the first region and the second region of the connecting member. This allows a current flowing through the plurality of battery cells to be detected with a simple configuration.
(9) According to still another aspect of the present invention, an electric vehicle includes a battery module, a motor arranged to be driven by power supplied from the battery module, and a drive wheel rotated by a torque of the motor, wherein the battery module includes a plurality of battery cells, a connecting member arranged to connect at least two electrodes of the plurality of battery cells to each other, and a voltage detector arranged to detect a voltage between a first region and a second region of the connecting member that are spaced apart from each other.

In the electric vehicle, the motor is driven by the power supplied from the battery module. The drive wheel is rotated by the torque of the motor to cause the electric vehicle to move.

In the battery module, the at least two electrodes of the plurality of battery cells are connected to each other through the connecting member. The voltage between the first region and the second region of the connecting member that are spaced apart from each other is detected by the voltage detector.

A value of a current flowing between the first region and the second region of the connecting member is calculated based on the voltage detected by the voltage detector and resistance between the first region and the second region of the connecting member. This allows a current flowing through the plurality of battery cells to be detected with a simple configuration.

Other features, elements, characteristics, and advantages of the present invention will become more apparent from the following description of preferred embodiments of the present invention with reference to the attached drawings.

### In the drawings

Fig. 1 is a block diagram showing the configuration of a battery system according to a first embodiment.
Fig. 2 is a perspective view showing the appearance of a battery module.
Fig. 3 is a plan view of the battery module.
Fig. 4 is a side view of the battery module.
Fig. 5 is a perspective view showing the appearance of a bus bar for two electrodes.
Fig. 6 is a perspective view showing the appearance of a bus bar for one electrode.
Fig. 7 is a perspective view showing the appearance of FPC boards to which a plurality of bus bars are attached.
Fig. 8 is a schematic plan view for explaining connection between the plurality of bus bars and a detecting circuit.
Fig. 9 is a schematic plan view showing respective connection states between two solder traces formed on a voltage/current bus bar and two conductor lines on the FPC board.
Fig. 10 is a circuit diagram showing an example of the configuration of the detecting circuit of Fig. 1.
Fig. 11 is a circuit diagram showing an example of the configuration of an amplifying circuit of Fig. 10.
Fig. 12 is a circuit diagram showing another example of the configuration of the detecting circuit of Fig. 1.
Fig. 13 is a diagram showing an example of the configuration of the detecting circuit having a current calculation function.
Fig. 14 is a schematic plan view showing the configuration of a voltage/current bus bar and peripheral members thereof according to a modification.
Fig. 15 is a block diagram showing the configuration of an electric automobile including the battery system of Fig. 1.

### [1] First Embodiment

Hereinafter, description will be made of a battery module according to a first embodiment and a battery system including the same while referring to the drawings. Note that the battery module and the battery system according to the present embodiment are mounted on an electric vehicle (an electric automobile, for example) using electric power as a driving source.

### (1) Configuration of the Battery System

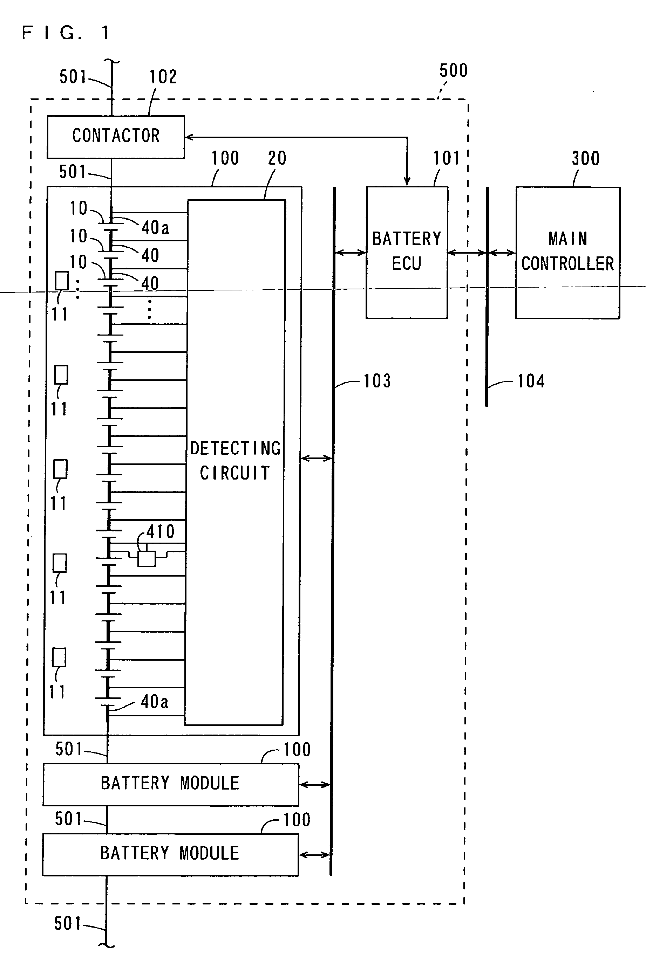

Fig. 1 is a block diagram showing the configuration of the battery system according to the first embodiment. As shown in Fig. 1, the battery system 500 includes a plurality of battery modules 100, a battery ECU (Electronic Control Unit) 101 and a contactor 102, and is connected to a main controller 300 of the electric vehicle via a bus 104.

The plurality of battery modules 100 of the battery system 500 are connected to one another through the power supply line 501. Each battery module 100 includes a plurality of (eighteen in this example) battery cells 10, a plurality of (five in this example) thermistors 11 and a detecting circuit 20.

In each battery module 100, the plurality of battery cells 10 are adjacent to one another to be integrally arranged, and are connected in series through a plurality of bus bars 40. Each of the battery cells 10 is a secondary battery such as a lithium-ion battery or a nickel metal hydride battery.

The battery cells 10 arranged at both ends of the battery module 100 are connected to the power supply line 501 through bus bars 40a. In this manner, all the battery cells 10 of the plurality of battery modules 100 are connected in series in the battery system 500. The power supply line 501 pulled out from the battery system 500 is connected to a load such as a motor of the electric vehicle.

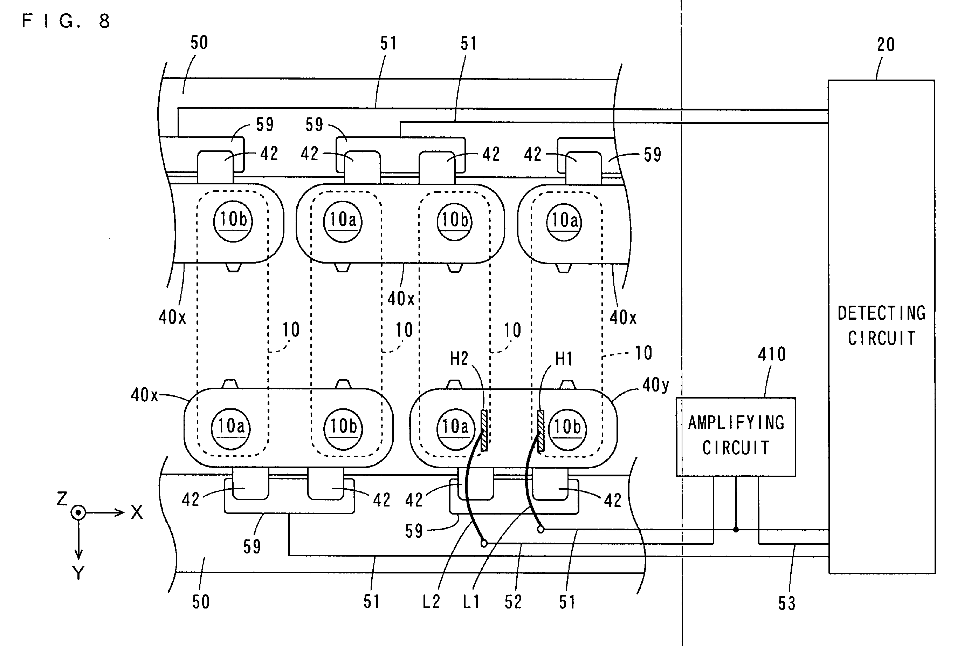

The detecting circuit 20 is connected to each of the bus bars 40, 40a through conductor lines 51 (see Fig. 8, described below). The detecting circuit 20 is electrically connected to each of the thermistors 11. The voltage (battery voltage) between terminals and the temperature of each battery cell 10 are detected by the detecting circuit 20.

The detecting circuit 20 of each battery module 100 is connected to the battery ECU 101 through a bus 103. This causes the voltage and temperature detected by the detecting circuit 20 to be given to the battery ECU 101.

Furthermore, an amplifying circuit 410 for amplifying an amount of voltage drop caused by a current flowing through each of the bus bars 40, 40a is provided between one bus bar 40 out of the plurality of bus bars 40, 40a and the detecting circuit 20 in the present embodiment. The detecting circuit 20 gives a voltage value based on an output voltage from the amplifying circuit 410 to the battery ECU 101. In this manner, the battery ECU 101 calculates a value of a current flowing through the plurality of battery cells 10. Details of the amplifying circuit 410 and details of calculation of the current value by the detecting circuit 20 and the battery ECU 101 will be described later.

The battery ECU 101 calculates the charged capacity of each battery cell 10 based on the voltage and temperature given from each detecting circuit 20 and the detected current, for example, and controls charging and discharging of each battery module 100 based on the charged capacity. In addition, the battery ECU 101 detects a state of each battery module 100 such as the life of the battery cells 10, abnormality and so on based on the given voltage and temperature and the detected current. Note that the abnormality of the battery module 100 includes overdischarge, overcharge or abnormal temperature of the battery cells 10, for example.

The contactor 102 is inserted in the power supply line 501 connected to the battery module 100 at one end of the battery system 500. The battery ECU 101 turns off the contactor 102 when it detects the abnormality of the battery module 100. Since the current does not flow through each battery module 100 in the case of an occurrence of the abnormality, the battery module 100 is prevented from being abnormally heated.

The battery ECU 101 is connected to the main controller 300 of the electric vehicle through the bus 104. The charged capacity of each battery module 100 (the charged capacity of each battery cell 10) is given from each battery ECU 101 to the main controller 300. The main controller 300 controls power of the electric vehicle (a rotational speed of the motor, for example) based on the charged capacity. When the charged capacity of each battery module 100 decreases, the main controller 300 controls a power generating system, not shown, connected to the power supply line 501 to cause each battery module 100 to be charged.

### (2) Details of the Battery Module

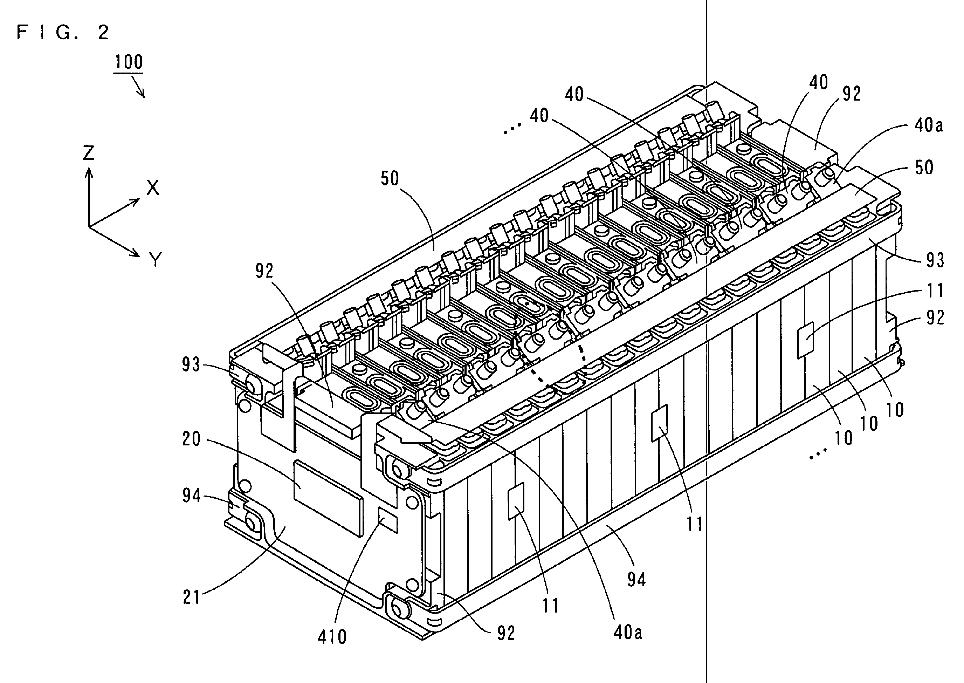

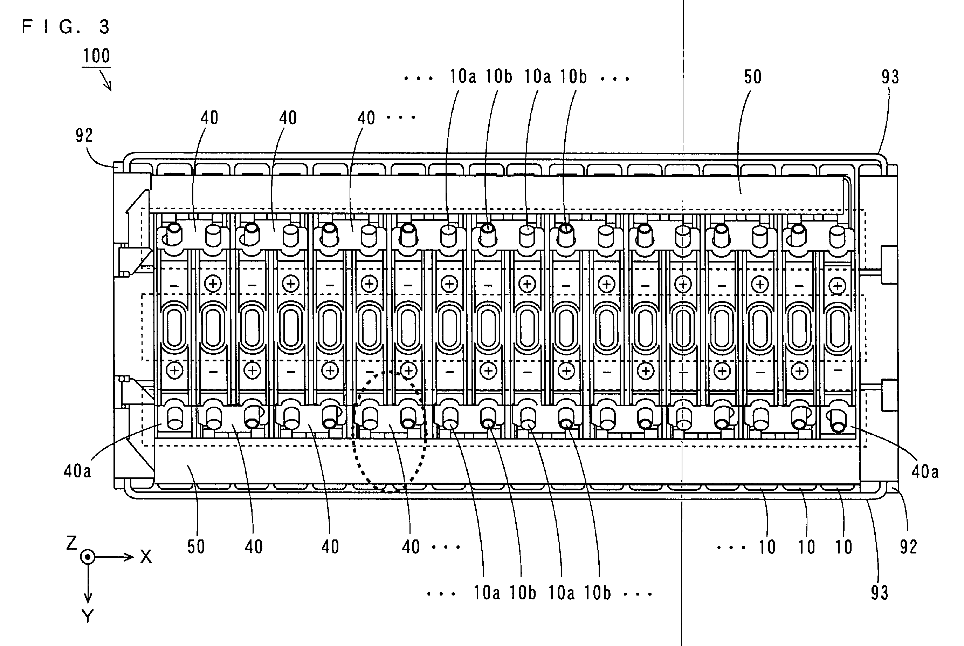

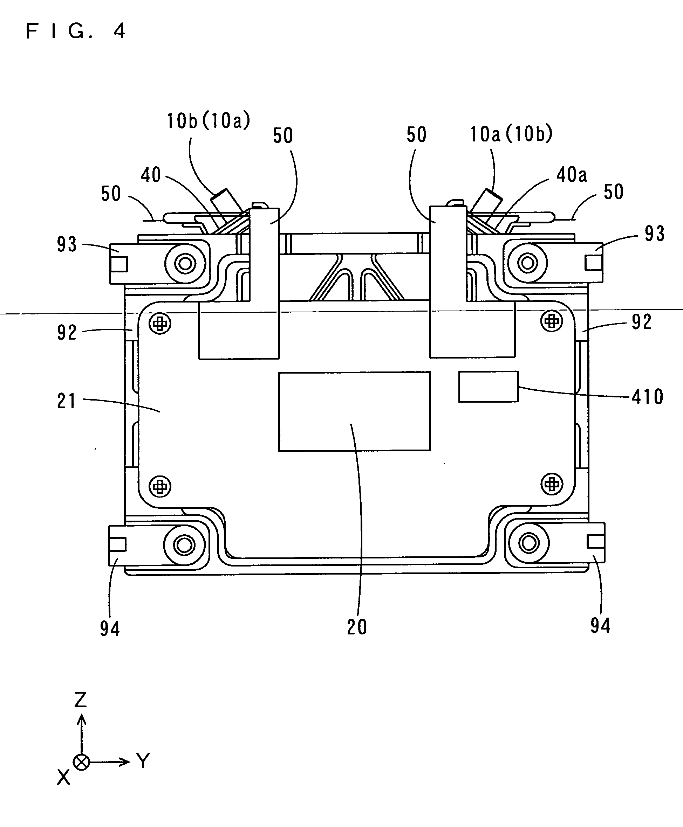

Description is made of details of the battery module 100. Fig. 2 is a perspective view showing the appearance of the battery module 100, Fig. 3 is a plan view of the battery module 100, and Fig. 4 is a side view of the battery module 100.

Note that in Figs. 2 to 4 and Figs. 7 to 9, described below, three directions that are perpendicular to one another are defined as an X-direction, a Y-direction and a Z-direction as indicated by the arrows X, Y, Z. Note that the X-direction and the Y-direction are parallel to a horizontal plane, and the Z-direction is perpendicular to the horizontal plane in this example.

As shown in Figs. 2 to 4, the plurality of battery cells 10 each having a flat and substantially rectangular parallelepiped shape are arranged along the X direction in the battery module 100. In this state, the plurality of battery cells 10 are integrally fixed by a pair of end surface frames 92, a pair of upper end frames 93 and a pair of lower end frames 94.

Each of the pair of end surface frames 92 has a substantially plate shape, and is arranged in parallel with the YZ plane. The pair of upper end frames 93 and the pair of lower end frames 94 are arranged to extend in the X-direction.

Connection portions for connecting the pair of upper end frames 93 and the pair of lower end frames 94 thereto are formed at four corners of each of the pair of end surface frames 92. The pair of upper end frames 93 is attached to the upper connection portions of the pair of end surface frames 92, and the pair of lower end frames 94 is attached to the lower connection portions of the pair of end surface frames 92 while the plurality of battery cells 10 are arranged between the pair of end surface frames 92. Accordingly, the plurality of battery cells 10 are integrally fixed while being arranged along the X-direction.

A rigid printed circuit board (hereinafter abbreviated as printed circuit board) 21 is attached to an outer surface of one end surface frame 92 with a distance therebetween. The detecting circuit 20 and the amplifying circuit 410 are provided on the printed circuit board 21.

Here, the plurality of battery cells 10 each have a plus electrode 10a arranged on an upper surface portion on one end side or the other end side in the Y-direction, and have a minus electrode 10b arranged on an upper surface portion on the opposite side. Each of the electrodes 10a, 10b is provided to be inclined and project upward (see Fig. 4).

In the following paragraphs, the battery cell 10 adjacent to one end surface frame 92 (the end surface frame 92 to which the printed circuit board 21 is not attached) to the battery cell 10 adjacent to the other end surface frame 92 are referred to as a first battery cell 10 to an eighteenth battery cell 10.

In the battery module 100, the battery cells 10 are arranged such that the positional relationship between the plus electrode 10a and the minus electrode 10b of each battery cell 10 in the Y-direction is opposite to that of the adjacent battery cell 10, as shown in Fig. 3.

Thus, in two adjacent battery cells 10, the plus electrode 10a of one battery cell 10 is close to the minus electrode 10b of another battery cell 10, and the minus electrode 10b of the one battery cel1 10 is close to the plus electrode 10a of the another battery cell 10. In this state, the bus bar 40 is attached to the two electrodes being close to each other. This causes the plurality of battery cells 10 to be connected in series.

Specifically, the common bus bar 40 is attached to the plus electrode 10a of the first battery cell 10 and the minus electrode 10b of the second battery cell 10. The common bus bar 40 is attached to the plus electrode 10a of the second battery cell 10 and the minus electrode 10b of the third battery cell 10.

Similarly, the common bus bar 40 is attached to the plus electrode 10a of each of the battery cells 10 in odd numbers and the minus electrode 10b of each of the battery cells 10 in even numbers adjacent thereto. The common bus bar 40 is attached to the plus electrode 10a of each of the battery cells 10 in even numbers and the minus electrode 10b of each of the battery cells 10 in odd numbers adjacent thereto.

Meanwhile, the bus bar 40a for connecting the power supply line 501 from the exterior is attached to each of the minus electrode 10b of the first battery cell 10 and the plus electrode 10a of the eighteenth battery cell 10.

A long-sized flexible printed circuit board (hereinafter abbreviated as FPC board) 50 extending in the X-direction is connected in common to the plurality of bus bars 40, 40a on one end side of the plurality of battery cells 10 in the Y-direction. Similarly, a long-sized FPC board 50 extending in the X-direction is connected in common to the plurality of bus bars 40 on the other end side of the plurality of battery cells 10 in the Y-direction.

The FPC board 50 having bending characteristics and flexibility mainly includes a plurality of conductor lines 51, 52 (see Fig. 8, described below) formed on an insulating layer. Examples of the material for the insulating layer constituting the FPC board 50 include polyimide, and examples of the material for the conductor lines 51, 52 (see Fig. 8, described below) include copper.

Each FPC board 50 is bent inward at a right angle and further bent downward at an upper end portion of the one end surface frame 92 (the end surface frame 92 to which the printed circuit board 21 is attached) to be connected to the printed circuit board 21.

The plurality of bus bars 40, 40a are connected to the detecting circuit 20 through the plurality of conductor lines 51 (Fig. 8), described below, and the one bus bar 40 out of the bus bars 40, 40a is connected to the amplifying circuit 410 through the conductor lines 51, 52 (Fig. 8), described below while the FPC boards 50 are connected to the printed circuit board 21. Details will be described below.

### (3) The Configurations of the Bus Bar and the FPC Boards

Next, description is made of details of the configurations of the bus bars 40, 40a and the FPC boards 50. In the following paragraphs, the bus bar 40 for connecting the plus electrode 10a and the minus electrode 10b of the two adjacent battery cells 10 is referred to as the bus bar for two electrodes 40, and the bus bar 40a for connecting the plus electrode 10a or the minus electrode 10b of one battery cell 10 and the power supply line 501 is referred to as the bus bar for one electrode 40a.

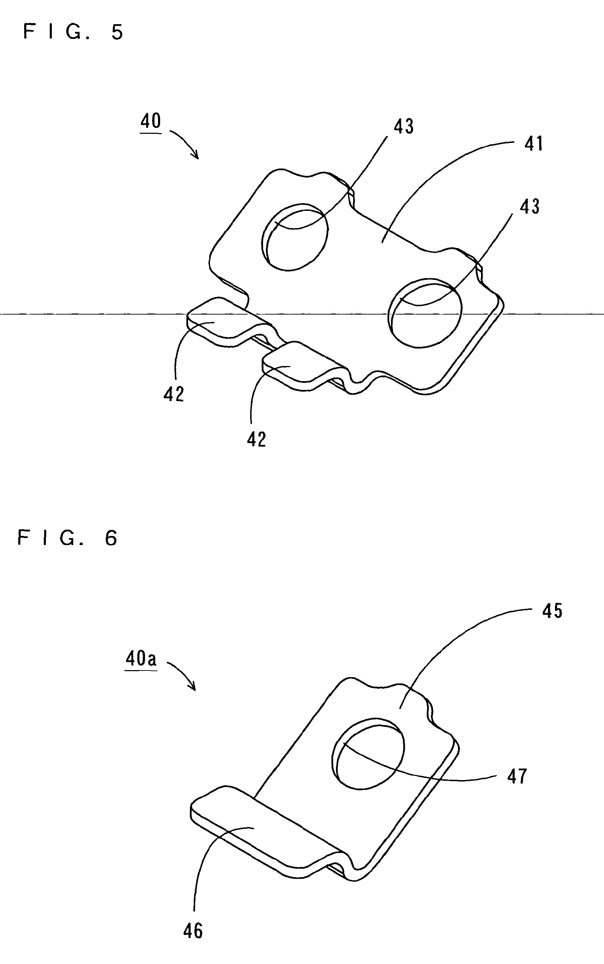

Fig. 5 is a perspective view showing the appearance of the bus bar for two electrodes 40, and Fig. 6 is a perspective view showing the appearance of the bus bar for one electrode 40a.

As shown in Fig. 5, the bus bar for two electrodes 40 includes a base portion 41 having a substantially rectangular shape and a pair of attachment portions 42 that is bent to extend toward one surface side from one side of the base portion 41. A pair of electrode connection holes 43 is formed in the base portion 41.

As shown in Fig. 6, the bus bar for one electrode 40a includes a base portion 45 having a substantially square shape and an attachment portion 46 that is bent to extend toward one surface side from one side of the base portion 45. An electrode connection hole 47 is formed in the base portion 45.

In the present embodiment, the bus bars 40, 40a are each composed of tough pitch copper having a nickel-plated surface, for example.

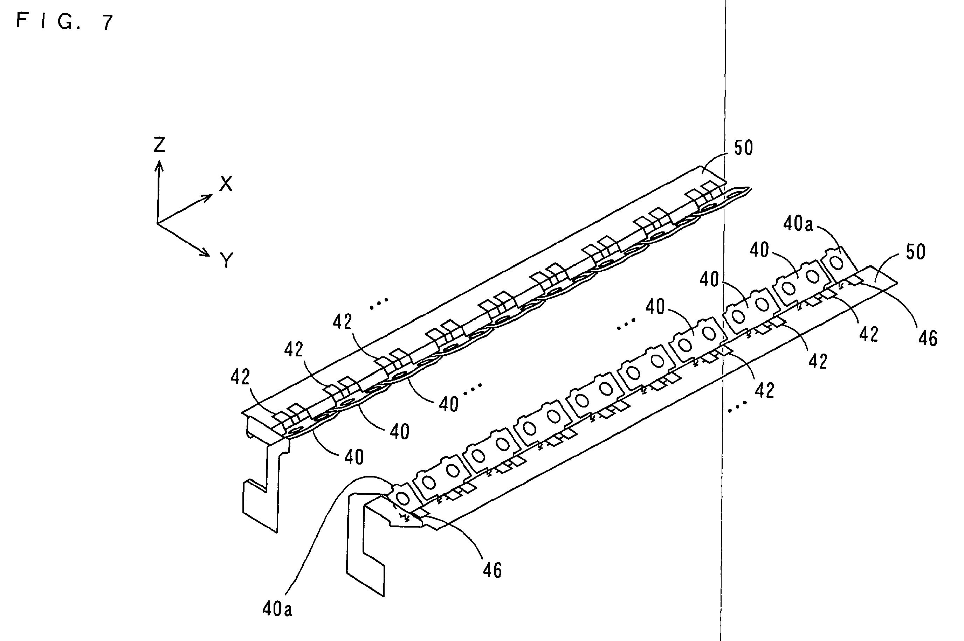

Fig. 7 is a perspective view showing the appearance of the FPC boards 50 to which the plurality of bus bars 40, 40a are attached. As shown in Fig. 7, the attachment portions 42, 46 of the plurality of bus bars 40, 40a are attached to the two FPC boards 50 at predetermined intervals along the X-direction.

The two FPC boards 50 with the plurality of bus bars 40, 40a attached thereto in the foregoing manner are provided on the plurality of battery cells 10 that are integrally fixed by the end surface frames 92 (Fig. 2), the upper end frames 93 (Fig. 2) and the lower end frames 94 (Fig. 2) during the manufacture of the battery module 100.

The electrode connection holes 43 formed in each bus bar for two electrodes 40 are fitted with the plus electrode 10a and the minus electrode 10b of the adjacent battery cells 10. Male threads are formed at the plus electrodes 10a and the minus electrodes 10b. With each of the bus bars for two electrodes 40 fitted with the adjacent plus electrode 10a and minus electrode 10b, the male threads of the plus electrodes 10a and the minus electrodes 10b are screwed in nuts (not shown).

The electrode connection holes 47 formed in the bus bars for one electrode 40a are fitted with the minus electrode 10b of the first battery cell 10 and the plus electrode 10a of the eighteenth battery cell 10. With the bus bars for one electrode 40a fitted with the minus electrode 10b and the plus electrode 10a, the male threads of the minus electrode 10b and the plus electrode 10a are screwed in nuts (not shown).

In this manner, the plurality of bus bars 40, 40a are attached to the plurality of battery cells 10 while the FPC boards 50 are held in a substantially horizontal attitude by the plurality of bus bars 40, 40a.

### (4) Connection between the Bus Bars and the Detecting Circuit

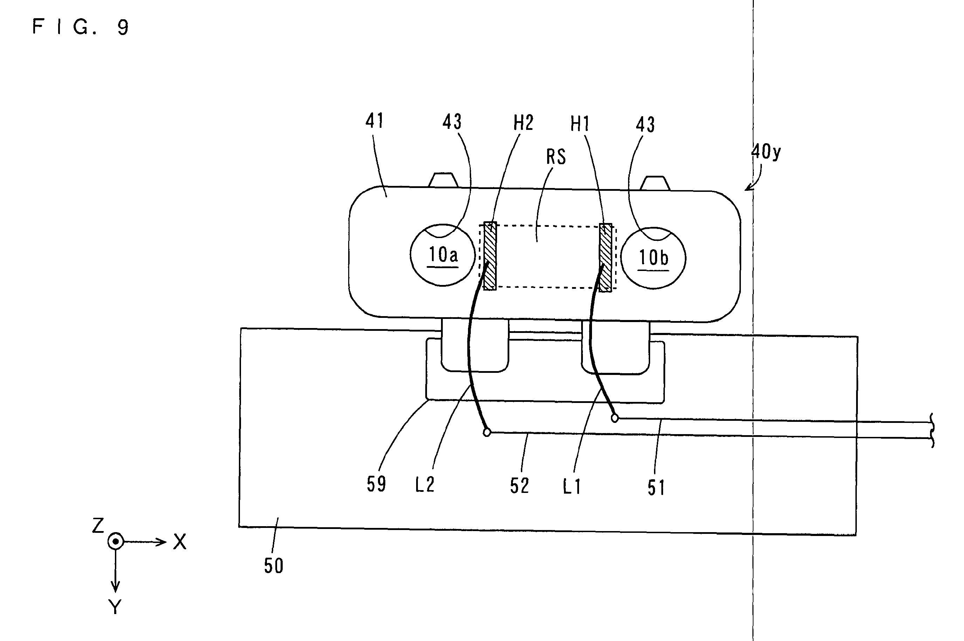

Description is made of connection between the plurality of bus bars 40, 40a and the detecting circuit 20. Figs. 8 and 9 are schematic plan views for explaining connection between the plurality of bus bars 40, 40a and the detecting circuit 20.

In the following description, the bus bars 40 that are not connected to the amplifying circuit 410 out of the plurality of bus bars 40, 40a are suitably referred to as voltage bus bars 40x, and the bus bar 40 that is connected to the amplifying circuit 410 out of the plurality of bus bars 40 is suitably referred to as a voltage/current bus bar 40y.

As shown in Fig. 8, a plurality of conductive plates 59 and the plurality of conductor lines 51 corresponding to the plurality of bus bars 40x, 40y are provided in the FPC boards 50. The conductor line 52 corresponding to the voltage/current bus bar 40y is provided in the FPC board 50.

The attachment portions 42 of each of the bus bars 40x, 40y are attached to the corresponding conductive plate 59 on the FPC board 50 by soldering.

The conductive plate 59 corresponding to each voltage bus bar 40x is connected to the detecting circuit 20 through the conductor lines 51 and the conductor lines on the printed circuit board 21 of Fig. 1. This causes each voltage bus bar 40x to be electrically connected to the detecting circuit 20.

As shown in Fig. 9, a pair of solder traces H1, H2 is formed in parallel with each other at a regular interval on the base portion 41 of the voltage/current bus bar 40y. The solder trace H1 is arranged between the two electrode connection holes 43 to be close to one electrode connection hole 43, and the solder trace H2 is arranged between the two electrode connection holes 43 to be close to the other electrode connection hole 43. Resistance formed between the solder traces H1, H2 in the voltage/current bus bar 40y is referred to as shunt resistance RS for current detection.

The solder trace H1 of the voltage/current bus bar 40y is connected to the corresponding conductor line 51 on the FPC board 50 through a wire L1. The solder trace H2 of the voltage/current bus bar 40y is connected to the corresponding conductor line 52 on the FPC board 50 through a wire L2.

As shown in Fig. 8, the conductor line 51 corresponding to the voltage/current bus bar 40y is connected to one input terminal of the amplifying circuit 410 and the detecting circuit 20 through the conductor line on the printed circuit board 21 of Fig. 2.

The detecting circuit 20 detects the voltage between the terminals of the battery cells 10 based on the voltages of the voltage bus bars 40x and the voltage/current bus bar 40y.

The conductor line 52 corresponding to the voltage/current bus bar 40y is connected to the other input terminal of the amplifying circuit 410 through the conductor line on the printed circuit board 21 of Fig. 2. An output terminal of the amplifying circuit 410 is connected to the detecting circuit 20 through the conductor line 53 on the printed circuit board 21 of Fig. 2.

The detecting circuit 20 detects a voltage value between the solder traces H1, H2 based on an output voltage of the amplifying circuit 410. The voltage value detected by the detecting circuit 20 is given to the battery ECU 101 of Fig. 1.

The battery ECU 101 includes a CPU (Central Processing Unit) and a memory, for example. A value of the shunt resistance RS between the solder traces H1, H2 in the voltage/current bus bar 40y is previously stored in the memory of the battery ECU 101 in the present embodiment.

The battery ECU 101 calculates a value of a current flowing through the voltage/current bus bar 40y by dividing the voltage value between the solder traces H1, H2 given from the detecting circuit 20 by the value of the shunt resistance RS stored in the memory. In this manner, the value of the current flowing through the plurality of battery cells 10 is detected.

Here, the value of the shunt resistance RS is calculated based on a length, a cross sectional area and resistivity of conductors through which the current flow. Therefore, the solder traces H1, H2 are preferably formed such that the value of the shunt resistance RS in the voltage/current bus bar 40y can be accurately calculated.

The current mainly flows through regions between the plus electrodes 10a and the minus electrodes 10b at the time of charging and discharging of the battery cells 10.

Therefore, the solder traces H1, H2 are preferably formed so as to be close to the electrode connection holes 43, respectively, and extend in a direction perpendicular to a straight line connecting the centers of the electrode connection holes 43. Furthermore, it is preferable that the length of each of the solder traces H1, H2 is substantially equal to the diameter of each of the electrode connection holes 43.

The value of the shunt resistance RS may be previously calculated based on the length of each of the solder traces H1, H2, the distance between the solder traces H1, H2, the thickness of the base portion 41 and the resistivity of the base portion 41, and the calculated value may be stored in the memory in the battery ECU 101.

Alternatively, the value of the shunt resistance RS between the solder traces H1, H2 may be previously measured, and the measured value may be stored in the memory in the battery ECU 101.

The temperature of the voltage/current bus bar 40y may be detected by the thermistors 11, and the value of the shunt resistance RS stored in the memory in the battery ECU 101 may be corrected by the detected temperature.

### (5) Examples of the Configurations of the Detecting Circuit and the Amplifying Circuit

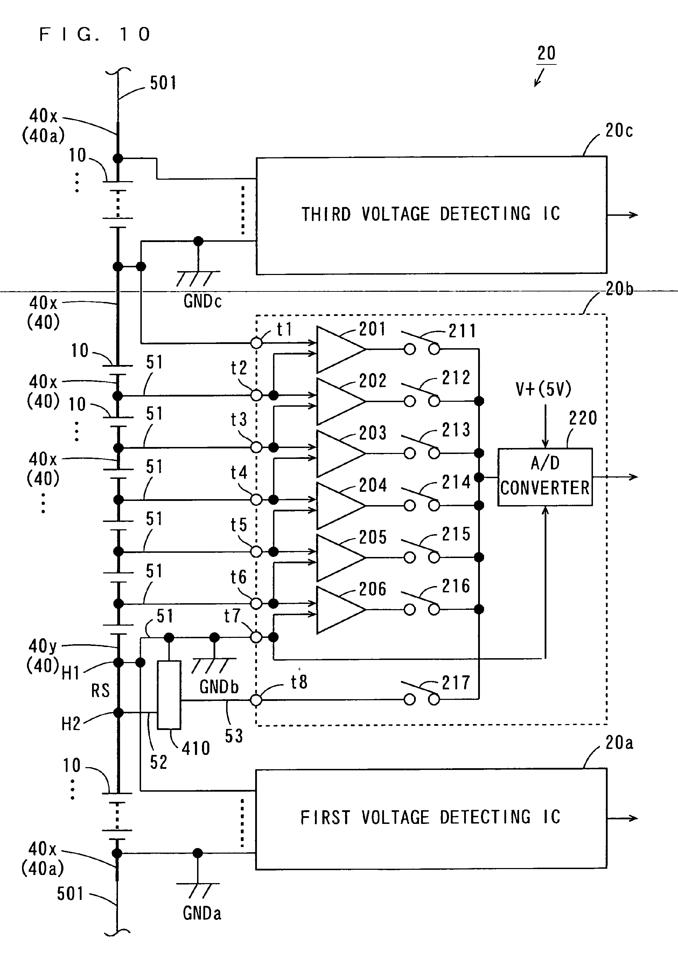

Fig. 10 is a circuit diagram showing an example of the configuration of the detecting circuit 20 of Fig. 1. The detecting circuit 20 shown in Fig. 10 includes first, second and third voltage detecting ICs (Integrated Circuits) 20a, 20b, 20c. The first voltage detecting IC 20a is provided corresponding to the first to sixth battery cells 10, the second voltage detecting IC 20b is provided corresponding to the seventh to twelfth battery cells 10, and the third voltage detecting IC 20c is provided corresponding to the thirteenth to eighteenth battery cells 10 in this example. The amplifying circuit 410 is connected to the second voltage detecting IC 20b. Note that reference voltages GNDa, GNDb, GNDc of the first to third voltage detecting ICs 20a, 20b, 20c are electrically independent from one another.

In the following paragraphs, the second voltage detecting IC 20b is representatively described. Note that the first and third voltage detecting ICs 20a, 20c each have the same configuration as the second voltage detecting IC 20b.

The second voltage detecting IC 20b includes eight input terminals t1 to t8. The input terminal t7is held at the reference voltage GNDb. The input terminals t7 to t1 are connected to the bus bars 40x, 40y provided between the sixth to thirteenth battery cells 10, respectively, through the conductor lines 51. In addition, the input terminal t8 is connected to the output terminal of the amplifying circuit 410 of Fig. 2 through the conductor line 53. One input terminal of the amplifying circuit 410 is connected to the solder trace H1 (Fig. 9) through the conductor line 51, and the other input terminal of the amplifying circuit 410 is connected to the solder trace H2 (Fig. 9) through the conductor line 52.

The second voltage detecting IC 20b includes voltage detectors 201 to 206, switching elements 211 to 217 and an A/D (Analog/Digital) converter 220.

The voltage detector 201 differentially amplifies a voltage between the input terminals t1, t2, the voltage detector 202 differentially amplifies a voltage between the input terminals t2, t3, the voltage detector 203 differentially amplifies a voltage between the input terminals t3, t4, the voltage detector 204 differentially amplifies s voltage between the input terminals t4, t5, the voltage detector 205 differentially amplifies a voltage between the input terminals t5, t6, and the voltage detector 206 differentially amplifies a voltage between the input terminals t6, t7. Furthermore, the amplifying circuit 410 amplifies the voltage between the solder traces H1, H2.

Output terminals of the voltage detectors 201 to 206 and the input terminal t8 are connected to an input terminal of the A/D converter 220 through the switching elements 211 to 217, respectively. The reference voltage GNDb of the input terminal t7 is fed to a reference terminal of the A/D converter 220, and a power supply voltage V+ is fed to a power supply terminal of the A/D converter 220.

While the reference voltage GNDb of the input terminal t7 is fed in common to the voltage detector 206 and the A/D converter 220 in this example, the reference voltage GNDb may be fed to the reference terminal of the A/D converter 220 separately from the voltage detector 206.

The switching elements 211 to 217 are sequentially turned on, so that the voltages amplified by the voltage detectors 201 to 206 and the amplifying circuit 410 are sequentially fed to the A/D converter 220. The A/D converter 220 converts the fed voltages to digital voltage values. The digital voltage values obtained by the A/D converter 220 are given to the battery ECU 101 of Fig. 1.

The charged capacity of each battery cell 10 is calculated in the battery ECU 101 based on the voltage value between the terminals of each battery cell 10, as described above. In addition, the value of the current flowing through the voltage/current bus bar 40y is calculated based on the voltage value between the solder traces H1, H2 and the value of the shunt resistance RS.

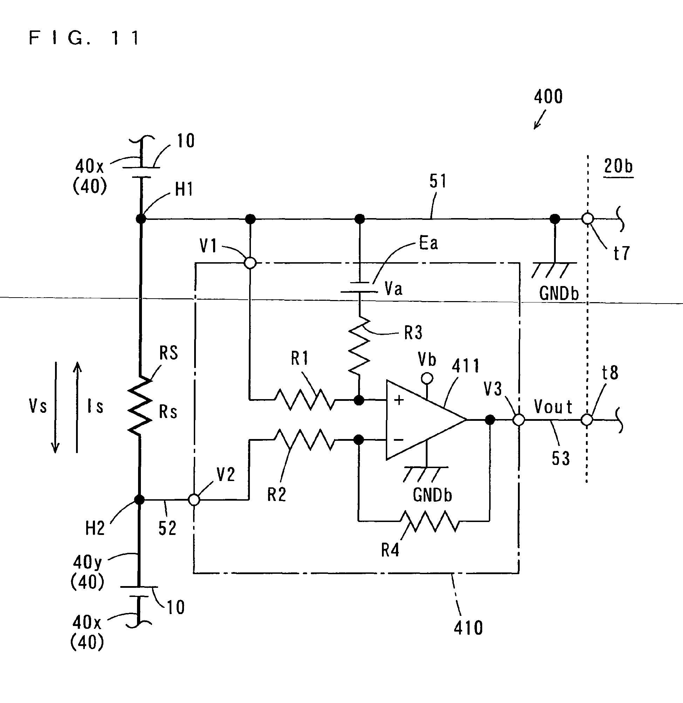

Fig. 11 is a circuit diagram showing an example of the configuration of the amplifying circuit 410 of Fig. 10. Here, description is made of details of the amplifying circuit 410 provided corresponding to the second voltage detecting IC 20b of Fig. 10. Hereinafter, the value of the shunt resistance RS between the solder traces H1, H2 is referred to as a shunt resistance value Rs, the value of the voltage between the solder traces H1, H2 is referred to as a voltage value Vs, and the value of the current flowing through the shunt resistance RS is referred to as a current value Is.

When the shunt resistance value Rs is known, the current value Is can be calculated by detecting the voltage value Vs.

As described above, the voltage/current bus bar 40y has a small shunt resistance value Rs (about 1 mΩ, for example), because its main constituent is copper. In this case, the current value Is changes in a range from -100 A to 100 A, and the voltage value Vs changes in a range from -0.1 V to 0.1 V, for example. Note that the direction of the current flowing through the voltage/current bus bar 40y at the time of charging is opposite to that at the time of discharging, so that a negative current value Is and a negative voltage value Vs are obtained.

Here, the second voltage detecting IC 20b detects the voltage between the terminals of each battery cell 10 changing in a range from 2.5 V to about 4.2 V, for example. Meanwhile, the voltage value Vs between the solder traces H1, H2 is lower than the voltage between the terminals of each battery cell 10. Therefore, the voltage value Vs between the solder traces H1, H2 is amplified by the amplifying circuit 410 in the present embodiment.

The input terminals V1, V2 and the output terminal V3 of the amplifying circuit 410 are connected to the conductor lines 51, 52 and 53, respectively. The amplifying circuit 410 is constituted by an operational amplifier 411, a DC power supply Ea and resistances R1 to R4.

A non-inverting input terminal of the operational amplifier 411 is connected to the input terminal V1 through the resistance R1 while being connected to a positive electrode of the DC power supply Ea through the resistance R3. An inverting input terminal of the operational amplifier 411 is connected to the input terminal V2 through the resistance R2. The resistance R4 is connected between the inverting input terminal and the output terminal V3 of the operational amplifier 411. The reference voltage GNDb is fed to the reference terminal of the operational amplifier 411, and a power supply voltage Vb is given to a power supply terminal.

A voltage (hereinafter referred to as an offset voltage) Va of the positive electrode of the DC power supply Ea is set to an intermediate value between the reference voltage GNDb and the power supply voltage Vb. Thus, when the voltage value Vs changes in a range between a negative value and a positive value, a voltage value Vout of the output terminal of the amplifying circuit 410 changes in a range between 0 V and the power supply voltage Vb, centered at the offset voltage Va.

For example, the values of the resistances R1, R2 are each set to 10 ki2, and the values of the resistances R3, R4 are each set to 250 kΩ. In this case, an amplifier gain of the amplifying circuit 410 is 25. Moreover, the power supply voltage Vb is set to 5 V, and the offset voltage Va is set to 2.5 V. As described above, when the shunt resistance value Rs is about 1 mΩ, the amplifying circuit 410 amplifies the voltage value Vs changing in the range from -0.1 V to 0.1 V to a voltage in a range from 0 V to 5 V, centered at 2.5 V.

When the voltage value Vs is -0.1 V, the output voltage of the amplifying circuit 410 is 5 V.

In this case, the current value Is is calculated as -100 A. In addition, when the voltage value Vs is 0 V, the output voltage of the amplifying circuit 410 is 2.5 V. In this case, the current value Is is calculated as 0 A. Furthermore, when the voltage value Vs is 0.1 V, the output voltage of the amplifying circuit 410 is 0 V. In this case, the current value Is is calculated as 100 A.

Next, description is made of the reason why the bus bar 40 connected to the input terminal t7 of the second voltage detecting IC 20b is used as the shunt resistance RS for current detection.

The voltage of the input terminal t6 changes in a range from about 2.5 V to about 4.2 V, centered at the voltage (3.7 V, for example) of one battery cell 10. The voltage of the input terminal t5 changes in a range from about 5 V to about 8.4 V, centered at the voltage (7.4 V, for example) of two battery cells 10. The input voltage range and the output voltage range of the operational amplifier 411 are each from the reference voltage GNDb to the power supply voltage Vb (from 0 V to 5 V, for example).

Therefore, when the bus bar 40 connected to the input terminal t5 is used as the shunt resistance RS and the both ends (the solder traces H1, H2) of the shunt resistance RS are connected to the input terminals V1, V2 of the amplifying circuit 410, the amplifier gain needs to be reduced such that the voltage between the non-inverting input terminal and the inverting input terminal of the operational amplifier 411 is within the foregoing input voltage range. For example, when the voltage of the input terminal V1 of the amplifying circuit 410 attains the maximum voltage (8.4 V) of the input terminal t5 of the second voltage detecting IC 20b, the amplifier gain of the amplifying circuit 410 is set to 0.73 or less, for example, in order to set the voltage of the non-inverting input terminal of the operational amplifier 411 to 5 V or less. In this case, it is difficult to detect the value Is of the current flowing through the shunt resistance RS since the range of change of the output voltage Vout of the amplifying circuit 410 is significantly reduced.

It is more difficult to detect the current value Is when the shunt resistance RS is grounded at the input terminals t4 to t1 that are spaced apart from the input terminal t7 held at the reference voltage GNDb.

Note that when an operational amplifier having a large input voltage range and a large output voltage range is used, the bus bars 40 that are connected to the input terminals t6 to t1 other than the input terminal t7 can be used as the shunt resistance RS. However, such an operational amplifier is expensive.

Accordingly, the bus bar 40 connected to the input terminal t7 held at the reference voltage GNDb is preferably used as the shunt resistance RS for current detection as shown in Figs. 10 and 11.

Note that the bus bar 40a connected to the input terminal held at the reference voltage GNDa has the configuration shown in Fig. 6 in the first voltage detecting IC 20a. Therefore, it is difficult to provide the two solder traces H1, H2 at a predetermined distance from each other in the bus bar 40a. In this case, the base portion 45 of the bus bar 40a is formed in a rectangular shape similarly to the base portion 41 of the bus bar 40 of Fig. 5, thereby allowing the two solder traces H1, H2 to be provided with a predetermined distance therebetween. However, the battery module 100 may have to be designed with its length in the X-direction being longer than that when the bus bar 40a of Fig. 6 is used. Therefore, it is not preferable to form the base portion 45 of the bus bar 40a in a rectangular shape from the point of view of size reduction of the battery module 100.

While the amplifying circuit 410 is connected to the second voltage detecting IC 20b out of the first to third voltage detecting ICs 20a, 20b, 20c of the detecting circuit 20 in the above description, the amplifying circuit 410 may be connected to the third voltage detecting IC 20c. Moreover, the amplifying circuit 410 may be connected to a plurality of voltage detecting ICs out of the first to third voltage detecting ICs 20a, 20b, 20c.

### (6) Another Example of the Configuration of the Detecting Circuit

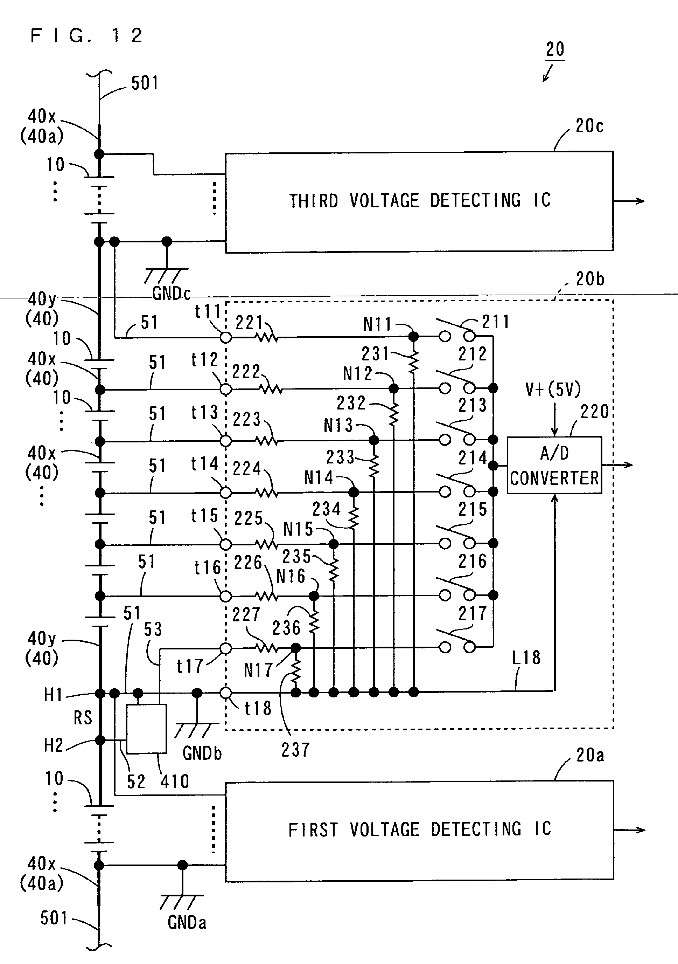

The detecting circuit 20 of Fig. 1 may have the following configuration instead of the configuration of Fig. 10. Fig. 12 is a circuit diagram showing another example of the configuration of the detecting circuit 20 of Fig. 1.

The detecting circuit 20 of Fig. 12 includes the first, second and third voltage detecting ICs 20a, 20b, 20c having the same configuration. Hereinafter, description is made of details of the second voltage detecting IC 20b of this example.

The second voltage detecting IC 20b has eight input terminals t11 to t18. The input terminal t18 is held at the reference voltage GNDb. The input terminals t18, t16 to t11 are connected to the bus bars 40x, 40y provided between the sixth to thirteenth battery cells 10, respectively, through the conductor lines 51. The input terminal t17 is connected to the output terminal of the amplifying circuit 410 of Fig. 2 through the conductor line 53.

Note that the amplifying circuit 410 of Fig. 12 has the same configuration as the amplifying circuit 410 of Fig. 11. Accordingly, the voltage value Vs between the solder traces H1, H2 amplified by the amplifying circuit 410 is input to the input terminal t17.

The second voltage detecting IC 20b includes resistances 221 to 227, 231 to 237, the switching elements 211 to 217 and the A/D converter 220.

The resistances 221, 231 are connected in series between the input terminal t11 and the input terminal t18, the resistances 222, 232 are connected in series between the input terminal t12 and the input terminal t18, and the resistances 223, 233 are connected in series between the input terminals t13 and the input terminal t18.

The resistances 224, 234 are connected in series between the input terminal t14 and the input terminal t18, the resistances 225, 235 are connected in series between the input terminal t15 and the input terminal t18, the resistances 226, 236 are connected in series between the input terminal t16 and the input terminal t18, and the resistances 227, 237 are connected in series between the input terminal t17 and the input terminal t18. Accordingly, each of the voltages of the input terminals t11 to t17 is divided.

A node N11 between the resistance 221 and the resistance 231, a node N12 between the resistance 222 and the resistance 232, a node N13 between the resistance 223 and the resistance 233, a node N14 between the resistance 224 and the resistance 234, a node N15 between the resistance 225 and the resistance 235, a node N16 between the resistance 226 and the resistance 236, and a node N17 between the resistance 227 and the resistance 237 are connected to the input terminal of the A/D converter 220 through the switching elements 211 to 217, respectively. The reference voltage GNDb of the input terminal t18 is given to the reference terminal of the A/D converter 220, and the power supply voltage V+ is given to the power supply terminal of the A/D converter 220.

The switching elements 211 to 217 are sequentially turned on, so that voltages of the nodes N11 to N17 are sequentially fed to the A/D converter 220.

Here, the resistances 221 to 227 and the resistances 231 to 237 are set such that the voltages of the nodes N11 to N17 change from the reference voltage GNDb to not more than the power supply voltage V+ of the A/D converter 220.

The A/D converter 220 converts the fed voltages to digital voltage values. The digital voltage values obtained by the A/D converter 220 are given to the battery ECU 101 of Fig. 1.

Thus, the charged capacity of each battery cell 10 is calculated based on the voltage value of each battery cell 10 by the battery ECU 101 similarly to the one example of the configuration of the detecting circuit 20 of Fig. 10. In addition, the value Is of the current flowing through the voltage/current bus bar 40y is calculated based on the voltage value Vs between the solder traces H1, H2 and the shunt resistance value Rs.

The bus bar 40 connected to the input terminal t18 held at the reference voltage GNDb is used as the shunt resistance RS for current detection similarly to the example of the configuration of Fig. 10. The reason will be described below.

The voltages input from the bus bars 40 to the input terminals t18 to t11 become higher in this order in this example. Therefore, the voltage input to each of the input terminals needs to be set at a larger ratio of voltage division with increasing distance from the input terminal t18. In this case, detection errors of the input voltages are liable to occur with increasing distance from the input terminal t18. Therefore, the bus bar 40 connected to the input terminal t18 held at the reference voltage GNDb is preferably used as the shunt resistance RS for current detection similarly to the example of Figs. 10 and 11.

### (7) Effects

(a) As described above, the voltage between the solder traces H1, H2 that are spaced apart from each other of the voltage/current bus bar 40y connecting the two battery cells 10 is detected by the amplifying circuit 410 and the detecting circuit 20 in the battery system 500 according to the present embodiment. The value of the current flowing through the voltage/current bus bar 40y is calculated by the battery ECU 101 based on the detected voltage and the shunt resistance RS between the solder traces H1, H2. This allows the current flowing through the plurality of battery cells 10 to be detected with a simple configuration.
(b) The plurality of bus bars 40 are metallic plates that connect the electrodes 10a, 10b of the adjacent battery cells 10 to each other. At least one of the plurality of bus bars 40 is used as the voltage/current bus bar 40y. In the voltage/current bus bar 40y, the solder traces H1, H2 are formed at a distance from each other between the minus electrode 10b of one battery cell 10 and the plus electrode 10a of the other battery cell 10 of the two adjacent battery cells 10.

In this case, part of the base portion 41 of the voltage/current bus bar 40y can be used as the shunt resistance RS for current detection. Accordingly, the electrodes 10a, 10b of the adjacent battery cells 10 are reliably connected, and the current flowing through the battery cells 10 can be detected.
(c) The solder traces H1, H2 are provided in the base portion 41 of the voltage/current bus bar 40y to extend substantially in parallel with each other. In this case, the sufficient shunt resistance value Rs for detecting the current can be ensured in part of the voltage/current bus bar 40y.
(d) In the present embodiment, the battery module 100 includes the eighteen battery cells 10, which are connected in series through the plurality of bus bars 40. The detecting circuit 20 detects the voltages among the terminals of the plurality of battery cells 10 and the voltage between the solder traces H1, H2 in the voltage/current bus bar 40y by detecting the voltages of the plurality of bus bars 40, 40a. Accordingly, the common detecting circuit 20 can detect the voltage between the terminals of each of the battery cells 10 and detect the current flowing through the plurality of battery cells 10.
(e) The voltage between the solder traces H1, H2 in the voltage/current bus bar 40y is amplified by the amplifying circuit 410. Here, the one solder trace H1 of the voltage/current bus bar 40y is connected to the reference terminal of the A/D converter 220. Accordingly, the voltage between the solder traces H1, H2 can be amplified to the sufficiently large value without using an expensive amplifying circuit having a large operating voltage range. Since the expensive amplifying circuit is not required, lower cost can be achieved.

### (8) Modification in the First Embodiment

(a) While the bus bars 40, 40a are each constituted by tough pitch copper having a nickel-plated surface in the foregoing description, the material constituting the bus bars 40, 40a is not limited to the same.
   The material constituting the bus bars 40, 40a is preferably selected based on strength, electrical resistivity and so on. In this case, a copper alloy, an aluminum alloy and so on having high strength and low electrical resistivity can be used.
(b) The voltage/current bus bar 40y may be formed of a different material from the material constituting other voltage bus bars 40x. Example of the material constituting the voltage/current bus bar 40y may include a material having low electrical resistivity (having high electrical conductivity) such as silver and gold.
(c) While the material constituting the conductive plate 59 is not descried in the foregoing paragraphs, the conductive plate 59 may be formed of a material that is the same as the material constituting the bus bars 40, 40a, or formed of a different material from that of the bus bars 40, 40a that is selected based on strength, electrical resistivity and so on.
(d) While the battery ECU 101 calculates the value of the current flowing through the voltage/current bus bar 40y based on the voltage value between the solder traces H1, H2 of the voltage/current bus bar 40y and the value of the shunt resistance RS in the foregoing description, the present invention is not limited to this. Instead of the battery ECU 101, the detecting circuit 20 may have a current calculation function.

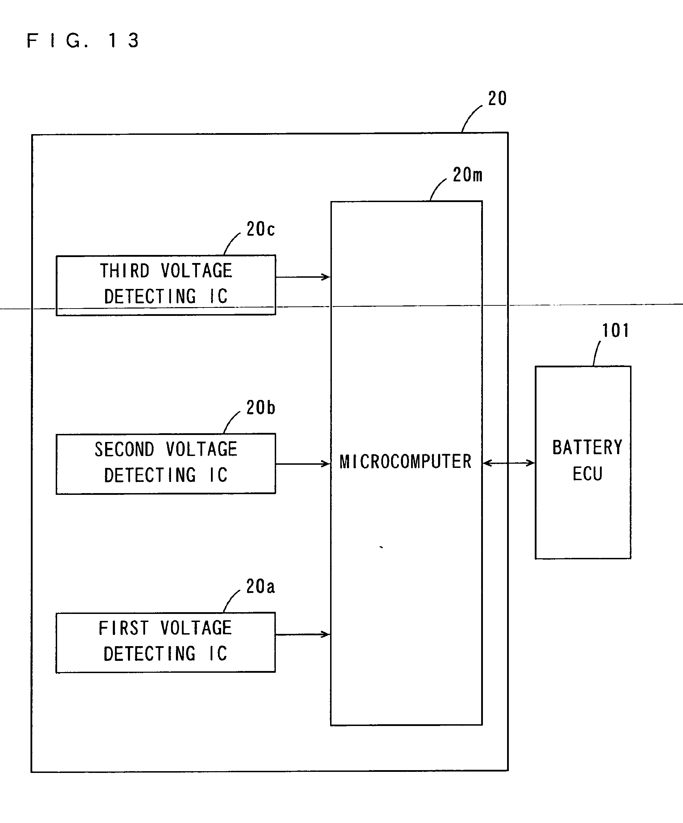

Fig. 13 is a diagram showing an example of the configuration of the detecting circuit 20 having the current calculation function. As shown in Fig. 13, a microcomputer 20m is provided in the detecting circuit 20 in addition to the configuration of Fig. 10, for example. Then, the value of the shunt resistance RS between the solder traces H1, H2 in the voltage/current bus bar 40y is previously stored in the microcomputer 20m of the detecting circuit 20.

Thus, the microcomputer 20m of the detecting circuit 20 may calculate the value is of the current flowing through the voltage/current bus bar 40y based on the voltage value Vs between the solder traces H1, H2 output from the second voltage detecting IC 20b of Fig. 10 and the shunt resistance value Rs.

Furthermore, in this case, the microcomputer 20m of the detecting circuit 20 may calculate the voltage between the terminals of each of the battery cells 10 based on the output of the first to third voltage detecting ICs 20a to 20c.

As described above, the calculated current value Is and the calculated voltage between the terminals of each of the battery cells 10 are given to the battery ECU 101.

In addition, the microcomputer 20m of the detecting circuit 20 may calculate the charged capacity of each battery cell 10 based on the calculated current value Is, the calculated voltage between the terminals of each of the battery cells 10, and the temperature of each battery cell 10 detected by the thermistor 11 of Fig. 1.

In this case, the calculated current value Is, the calculated voltage between the terminals of each battery cell 10, the detected temperature of each battery cell 10 and the charged capacity of each battery cell1 10 are given from the microcomputer 20m to the battery ECU 101.

While the microcomputer 20m is provided in the detecting circuit 20 in this example, a CPU and a memory instead of the microcomputer 20m may be provided to realize the current calculation function.

The microcomputer 20m or the CPU and the memory of this example may be provided on the printed circuit board 21 of Fig. 4, for example.
(e) The two solder traces H1, H2 are provided in the base portion 41 of the voltage/current bus bar 40y as part of the configuration for detecting the current flowing through the battery module 100 in the foregoing description. Instead of this, the voltage/current bus bar 40y and peripheral members thereof may have the following configuration.

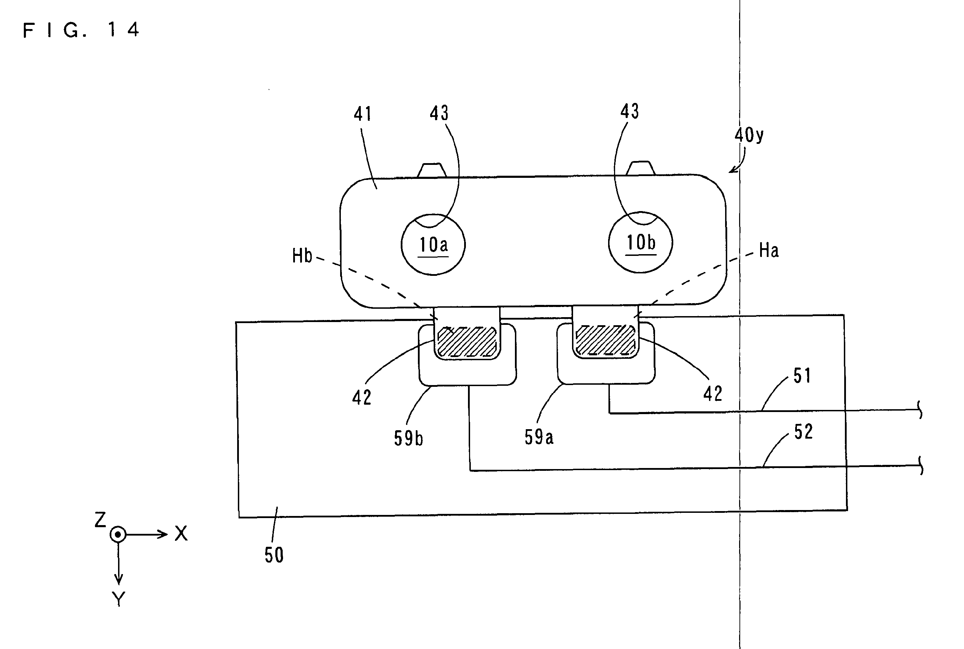

Fig. 14 is a schematic plan view showing the configuration of the voltage/current bus bar 40y and peripheral members thereof according to a modification. As shown in Fig. 14, two conductive plates 59a, 59b that are separated from each other are provided in a connection section of the voltage/current bus bar 40y in the FPC board 50. One attachment portion 42 of the voltage/current bus bar 40y is attached to the one conductive plate 59a by soldering, and the other attachment portion 42 of the voltage/current bus bar 40y is attached to the conductive plate 59b by soldering.

In this example, a solder portion Ha at which the one attachment portion 42 of the voltage/current bus bar 40y is soldered to the one conductive plate 59a, and a solder portion Hb at which the other attachment portion 42 of the voltage/current bus bar 40y is soldered to the other conductive plate 59b correspond to the above-described solder traces H1, H2, respectively.

The conductor line 51 corresponding to the voltage/current bus bar 40y is connected to the one conductive plate 59a. The conductor line 52 corresponding to the voltage/current bus bar 40y is connected to the other conductive plate 59b.

The one attachment portion 42 of the voltage/current bus bar 40y is connected to the detecting circuit 20 through the one solder portion Ha, the conductive plate 59a, the conductor line 51 and the conductor line on the printed circuit board 21 of Fig. 2. Moreover, the other attachment portion 42 of the voltage/current bus bar 40y is connected to the input terminal V2 of the amplifying circuit 410 of Fig. 11 through the other solder portion Hb, the conductive plate 59b, the conductor line 52 and the conductor line on the printed circuit board 21 of Fig. 2. The output terminal V3 of the amplifying circuit 410 is connected to the detecting circuit 20 through the conductor line 53 (Fig. 11) on the printed circuit board 21 of Fig. 2.

In this case, the current flows between the solder portions Ha, Hb at the time of charging and discharging of the battery cells 10. Therefore, resistance formed between the solder portions Ha, Hb in the voltage/current bus bar 40y is taken as the shunt resistance RS for current detection.

The value of the shunt resistance RS between the solder portions Ha, Hb is previously measured, and the measured value is stored in the memory in the battery ECU 101, so that the current flowing through the voltage/current bus bar 40y can be calculated.

Accordingly, connecting lines for electrically connecting the solder portions Ha, Hb in the voltage/current bus bar 40y and the conductor lines 51, 52 of the FPC board 50, respectively, are not required in this example. This allows the battery module 100 to be easily manufactured with a simple configuration.

In addition, the one conductor line 51 out of the two conductor lines 51, 52 connected to the voltage/current bus bar 40y is used in common as the conductor line for detecting the current flowing through the battery module 100 and the conductor line for measuring the voltage between the terminals of the battery cells 10 in this example.
(f) While the configurations of the bus bars 40, 40a that are produced by forming the through holes in the metallic plates and being subjected to bending and other processing are described in the foregoing paragraphs (see Figs. 5 and 6), the bus bars 40, 40a may not be necessarily formed of metallic plates.

For example, the bus bar 40 of Fig. 5 may be replaced with a structure in which the pair of electrode connecting holes 43 corresponding to the electrodes 10a, 10b of each battery cell 10 is formed in a metallic block having a substantially rectangular parallelepiped shape.

In this case, the plus electrode 10a and the minus electrode 10b of the adjacent battery cells 10 are fitted in the pair of electrode connecting holes 43 formed in the bus bar 40. In this state, each of the electrodes 10a, 10b is subjected to caulking, thereby causing the bus bars 40 to be attached to the battery cells 10.

In addition, the bus bar 40a of Fig. 6 may be replaced with a structure in which the electrode connecting hole 47 corresponding to the plus electrode 10a or the minus electrode 10b of the battery cell 10 is formed in a metallic block having a cubic shape.

In this case, the plus electrode 10a or the minus electrode 10b of the battery cell 10 is fitted in the electrode connecting hole 47 formed in the bus bar 40a. In this state, the plus electrode 10a or the minus electrode 10b is subjected to caulking, thereby causing the bus bar 40a to be attached to the battery cell 10.
(g) Note that the circuit configuration of the detecting circuit 20 is not limited to the examples shown in Figs. 10 and 12. The detecting circuit 20 may have any circuit configuration capable of detecting at least the voltage between the solder traces H1, H2. In this case, the detecting circuit 20 preferably has a circuit configuration capable of further detecting the voltages between the terminals of the plurality of battery cells 10 by detecting the voltages of the plurality of bus bars 40, 40a.

The circuit configuration of the amplifying circuit 410 is not limited to the example shown in Fig. 11. The amplifying circuit 410 may have any circuit configuration capable of amplifying the voltage value Vs between the solder traces H1, H2.

### [2] Second Embodiment

Hereinafter, description will be made of an electric vehicle according to a second embodiment. The electric vehicle according to the present embodiment includes the battery modules 100 and the battery system 500 according to the first embodiment. Note that an electric automobile is described as one example of the electric vehicle in the following paragraphs.

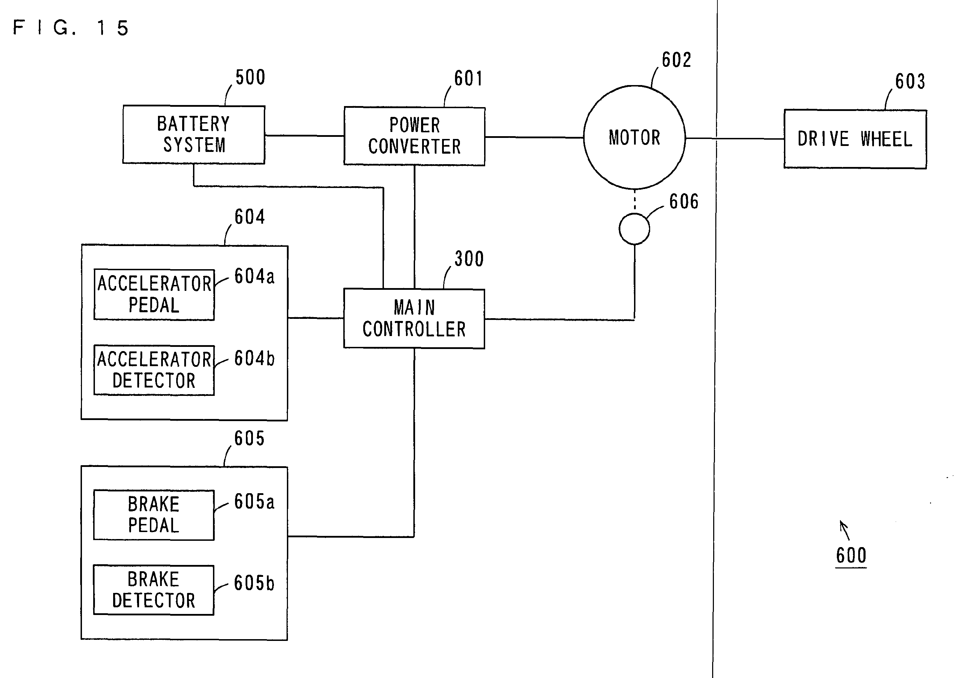

Fig. 15 is a block diagram showing the configuration of an electric automobile including the battery system 500 of Fig. 1. As shown in Fig. 15, the electric automobile 600 according to the present embodiment includes the main controller 300 and the battery system 500 of Fig. 1, a power converter 601, a motor 602, a drive wheel 603, an accelerator system 604, a brake system 605, and a rotational speed sensor 606. When the motor 602 is an alternate current (AC) motor, the power converter 601 includes an inverter circuit.

In the present embodiment, the battery system 500 is connected to the motor 602 through the power converter 601 while being connected to the main controller 300. As described in the foregoing, the charged capacity of the plurality of battery modules 100 (Fig. 1) and the value of the current flowing through the battery modules 100 are given from the battery ECU 101 (Fig. 1) constituting the battery system 500 to the main controller 300. Moreover, each of the accelerator system 604, the brake system 605 and the rotational speed sensor 606 is connected to the main controller 300. The main controller 300 is composed of a CPU and a memory or composed of a microcomputer, for example.

The accelerator system 604 includes an accelerator pedal 604a included in the electric automobile 600 and an accelerator detector 604b that detects an operation amount (depression amount) of the accelerator pedal 604a. When the accelerator pedal 604a is operated by a driver, the accelerator detector 604b detects the operation amount of the accelerator pedal 604a. Note that a state of the accelerator pedal 604a when not being operated by the driver is set as a reference. The detected operation amount of the accelerator pedal 604a is given to the main controller 300.

The brake system 605 includes a brake pedal 605a provided in the electric automobile 600 and a brake detector 605b that detects an operation amount (depression amount) of the brake pedal 605a by the driver. When the brake pedal 605a is operated by the driver, the operation amount is detected by the brake detector 605b. The detected operation amount of the brake pedal 605a is given to the main controller 300.

The rotational speed sensor 606 detects a rotational speed of the motor 602. The detected rotational speed is given to the main controller 300.

As described in the foregoing, the charged capacity of the battery module 100, the value of the current flowing through the battery modules 100, the operation amount of the accelerator pedal 604a, the operation amount of the brake pedal 605a and the rotational speed of the motor 602 are given to the main controller 300. The main controller 300 controls charging and discharging of the battery modules 100 and power conversion by the power converter 601 based on the information.

Power generated by the battery modules 100 is supplied from the battery system 500 to the power converter 601 at the time of starting and accelerating the electric automobile 600 based on the accelerator operation, for example.

Furthermore, the main controller 300 calculates a torque (commanded torque) to be transmitted to the drive wheel 603 based on the given operation amount of the accelerator pedal 604a, and gives a control signal based on the commanded torque to the power converter 601.

The power converter 601 receives the control signal, and converts the power supplied from the battery system 500 into power (driving power) required for driving the drive wheel 603. Accordingly, the driving power converted by the power converter 601 is supplied to the motor 602, and the torque of the motor 602 based on the driving power is transmitted to the drive wheel 603.

Meanwhile, the motor 602 functions as a power generation system at the time of decelerating the electric automobile 600 based on the brake operation. In this case, the power converter 601 converts regenerated power generated by the motor 602 to power suitable for charging the battery modules 100, and supplies the power to the battery module 100. This causes the battery modules 100 to be charged.

As described above, the battery system 500 according to the first embodiment is provided in the electric automobile 600 according to the present embodiment. In the battery system 500, the current flowing through the plurality of battery cells 10 is detected with a simple configuration. This allows the electric automobile 600 to be controlled based on the value of the current flowing through the battery modules 100.

### [3] Correspondences between Elements in the Claims and Parts in Embodiments

In the following paragraphs, non-limiting examples of correspondences between various elements recited in the claims below and those described above with respect to various preferred embodiments of the present invention are explained.

In the first and second embodiments, the plus electrode 10a and the minus electrode 10b are examples of at least two electrodes of the plurality of battery cells 10, the bus bar 40, the voltage bus bar 40x and the voltage/current bus bar 40y are examples of a connection member and a metal plate, regions in which the solder traces H1, H2 are formed (Fig. 9) on the base portion 41 are examples of a first region and a second region, respectively, the solder portions Ha, Hb (Fig. 14) of the voltage/current bus bar 40y are examples of a first region and a second region, respectively, the input terminals t1 to t8 of Fig. 10 and the input terminals t11 to t18 of Fig. 12 are examples of a plurality of input terminals, the input terminal t7 of Fig. 10 and the input terminal t18 of Fig. 12 are examples of a reference terminal, the detecting circuit 20 is an example of a voltage detector, the battery ECU 101, or the detecting circuit 20 of the modification, or the microcomputer 20m that is provided in the printed circuit board 21 is an example of a current calculator.

The conductor lines 51, 52 are examples of first and second conductor traces, respectively, the FPC board 50 is an example of a circuit board, the FPC board 50 is an example of a flexible member, the two attachment portions 42 of the voltage/current bus bar 40y are examples of first and second attachment portions, respectively, the two conductive plates 59a, 59b are examples of first and second conductive plates, respectively, the thermistor 11 and the detecting circuit 20 are examples of a temperature detector, and the memory of the battery ECU 101 is an example of a storage.

As each of various elements recited in the claims, various other elements having configurations or functions described in the claims can be also used.

While preferred embodiments of the present invention have been described above, it is to be understood that variations and modifications will be apparent to those skilled in the art without departing the scope and spirit of the present invention. The scope of the present invention, therefore, is to be determined solely by the following claims" as interpreted by the description and drawings,

## Claims

1. A battery module comprising:
a plurality of battery cells;
a connecting member arranged to connect at least two electrodes of said plurality of battery cells to each other; and
a voltage detector arranged to detect a voltage between a first region and a second region of said connecting member that are spaced apart from each other.

2. The battery module according to claim 1, further comprising a circuit board that includes first and second conductor traces that are electrically connected to said voltage detector, wherein
said connecting member is a metal plate arranged to connect electrodes of adjacent battery cells to each other,
said metal plate has said first and second regions, and
said first and second regions of said metal plate are joined to said first and second conductor traces of said circuit board, respectively.

3. The battery module according to claim 2, wherein
said circuit board includes a flexible member, and
said first and second conductor traces are provided on said flexible member.

4. The battery module according to claim 3, wherein
said circuit board further includes first and second conductive plates which are provided on said flexible member so as to be separated from each other and to which said first and second conductor traces are connected, respectively,
said metal plate includes a first attachment portion including said first region and a second attachment portion including said second region, and
said first and second conductive plates of said circuit board are attached to said first and second attachment portions, respectively.

5. The battery module according to claim 1, wherein
said plurality of battery cells include at least three battery cells,
said connecting member includes a plurality of metal plates, each of which connects electrodes of adjacent battery cells to each other such that said at least three battery cells are connected in series,
said first and second regions are provided in at least one of said plurality of metal plates, and
said voltage detector detects voltages of said plurality of battery cells by detecting voltages among said plurality of metal plates and detects the voltage between said first and second regions.

6. The battery module according to claim 1, further comprising an amplifying circuit arranged to amplify the voltage between said first and second regions, wherein
said voltage detector includes a plurality of input terminals arranged to receive voltages of said plurality of connecting members or an output voltage of said amplifying circuit, and includes a reference terminal held at a reference voltage of said voltage detector, and
said first region is connected to said reference terminal.

7. The battery module according to claim 1, further comprising:
a storage arranged to store a resistance value between said first region and said second region of said connecting member;
a current calculator arranged to calculate a current flowing between said first region and said second region based on the voltage detected by said voltage detector and the resistance value stored in said storage; and
a temperature detector arranged to detect a temperature of said plurality of battery cells, wherein
said current calculator corrects the resistance value stored in said storage based on the temperature detected by said temperature detector.

8. A battery system comprising:
a battery module; and
a current calculator, wherein
said battery module includes:
a plurality of battery cells;
a connecting member arranged to connect at least two electrodes of said plurality of battery cells to each other; and
a voltage detector arranged to detect a voltage between a first region and a second region of said connecting member that are spaced apart from each other, and
said current calculator calculates a current flowing through said connecting member based on the voltage between the first and second regions detected by said voltage detector of said battery module.

9. An electric vehicle comprising:
a battery module;
a motor arranged to be driven by power supplied from said battery module; and
a drive wheel rotated by a torque of said motor, wherein
said battery module includes:
a plurality of battery cells;
a connecting member arranged to connect at least two electrodes of said plurality of battery cells to each other; and
a voltage detector arranged to detect a voltage between a first region and a second region of said connecting member that are spaced apart from each other.
